# FASCICULE DE BREVET EUROPEEN

(11) **EP 3 360 172 B1**
(45) Date de publication et mention de la délivrance du brevet: **28.08.2019**
(21) Numéro de dépôt: 16793943.8
(22) Date de dépôt: 05.10.2016
(51) Int. Cl.: H01L 43/08, G11C 11/16

(54) **POINT MEMOIRE MAGNETIQUE**
MAGNETSPEICHERZELLE
MAGNETIC MEMORY CELL

(30) Priorité: 08.10.2015 FR 1559584
(43) Date de publication de la demande: 15.08.2018
(73) Titulaire: Centre National de la Recherche Scientifique, 75794 Paris Cedex 16 (FR); Commissariat à l'énergie atomique et aux énergies alternatives, 75015 Paris (FR)
(72) Inventeur: GAUDIN, Gilles, 38700 Le Sappey En Chartreuse (FR); MIRON, Ioan Mihai, 38000 Grenoble (FR); BOULLE, Olivier, 38000 Grenoble (FR); CHENATTUKUZHIYIL, Safeer, Kerala 673642 (IN)
(74) Mandataire: Lavoix
(86) Numéro de dépôt international: PCT/FR2016/052565
(87) Numéro de publication internationale: WO 2017/060626

(56) Documents cités:
- US-A1- 2009 273 972
- US-A1- 2010 207 220
- US-A1- 2012 020 152
- US-B1- 6 707 122

## Description

La présente demande concerne un point mémoire magnétique, et plus particulièrement un point mémoire magnétique de type à retournement induit par un courant.

### Exposé de l'art antérieur

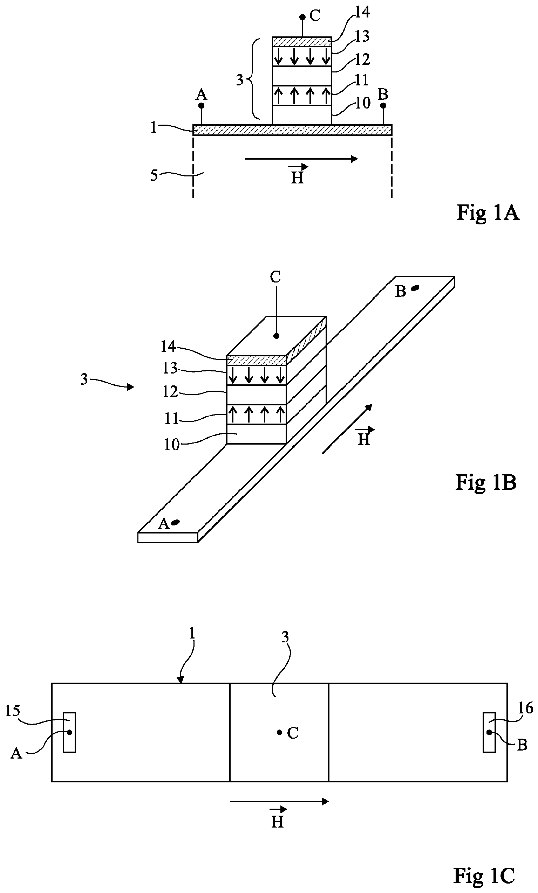

Le brevet français N°2 963 152 décrit un point mémoire magnétique tel que représenté schématiquement en figures 1A, 1B et 1C. Les figures 1A et 1B ci-après représentent respectivement une vue en coupe et une vue en perspective d'un point mémoire magnétique tel que décrit en relation avec les figures 1c-1f, 2a-2b et 3a-3d du brevet français N°2 963 152. La figure 1C est une vue de dessus simplifiée de ce point mémoire.

Comme l'illustrent les figures 1A et 1B, ce point mémoire comprend, au-dessus d'une piste conductrice 1, un plot 3. Le plot 3 comprend un empilement de régions dont chacune est formée d'une portion d'une couche mince ou d'un empilement de plusieurs couches minces. La piste conductrice 1 est par exemple formée sur un substrat 5 constitué d'une plaquette de silicium revêtue d'une couche d'oxyde de silicium et est connectée entre des bornes A et B. L'empilement constituant le plot 3 comprend successivement à partir de la piste 1, une région 10 en un matériau conducteur non magnétique, une région 11 en un matériau magnétique, une région 12 en un matériau non magnétique, une région 13 en un matériau magnétique et une électrode 14. Le matériau de la couche 12 peut être conducteur ; c'est de préférence un matériau isolant suffisamment mince pour pouvoir être traversé par des électrons par effet tunnel. Il existe une différence structurelle entre les régions non magnétiques 10 et 12 de façon à avoir un système asymétrique dans une direction orthogonale au plan des couches. Cette différence peut résulter notamment d'une différence de matériau, d'épaisseur, ou de mode de croissance de ces couches.

Des listes de matériaux pouvant constituer les diverses couches sont données dans la demande de brevet susmentionnée. Les matériaux magnétiques des régions 11 et 13 sont formés dans des conditions telles qu'ils présentent une aimantation dirigée orthogonalement au plan des couches. Le matériau magnétique de la couche 13 est formé dans des conditions telles qu'il conserve une aimantation intangible (couche piégée). La couche d'électrode supérieure 14 est connectée à une borne C.

La programmation du point mémoire est effectuée en faisant circuler un courant entre les bornes A et B, tandis qu'un champ H orienté horizontalement (parallèlement au plan des couches et à la direction du courant entre les bornes A et B) est appliqué. Selon les sens relatifs du courant entre les bornes A et B et du vecteur de champ H, la couche 11 est programmée de sorte que son aimantation s'oriente vers le haut ou vers le bas.

Pour la lecture de ce point mémoire, une tension est appliquée entre la borne C et l'une ou l'autre des bornes A et B. Le courant résultant entre la borne C et l'une ou l'autre des bornes A et B prend des valeurs différentes selon le sens relatif des aimantations des couches 11 et 13 : valeur haute si les deux aimantations sont dans le même sens et valeur basse si les deux aimantations sont de sens opposés.

Une caractéristique du point mémoire décrit ci-dessus est que sa programmation se fait grâce à un courant circulant entre les bornes A et B et à un champ magnétique appliqué dans le plan des couches, parallèlement au courant. Aucun courant ne circule de la borne A ou B vers la borne C lors de la programmation. Ceci présente l'avantage de dissocier complètement les opérations de lecture et d'écriture du point mémoire.

De nombreuses variantes de réalisation sont possibles. Notamment, chaque couche décrite précédemment peut être constituée d'un empilement de couches de façon connue dans la technique pour acquérir les caractéristiques souhaitées.

La portion de couche 10 en un matériau conducteur non magnétique peut être omise, à condition que la piste 1 soit en un matériau non magnétique convenant à la croissance de la couche magnétique 11. La piste 1 peut alors présenter une surépaisseur sous le plot 3. Pour que le retournement de l'aimantation dans la couche 11 puisse se faire, il faut aussi que des couples de spin-orbite soient présents dans la couche magnétique. Pour ce faire, il faut par exemple que la couche en contact avec cette couche 11 (ou séparée d'elle par une couche séparatrice fine) soit constituée d'un matériau ou composée de matériaux à fort couplage spin-orbite. Une autre solution est, par exemple, que le contact entre la couche magnétique 11 et l'une ou l'autre des couches 10 et 12 crée ce couplage spin-orbite ; c'est ce qui peut par exemple arriver par hybridation de la couche magnétique 11 avec la couche 12 si celle-ci est constituée d'un isolant (voir "Spin-orbit coupling effect by minority interface resonance states in single-crystal magnetic tunnel junctions", Y. Lu et al. Physical Review B, Vol. 86, p.184420 (2012)).

On notera que le point mémoire des figures 1A et 1B peut être décomposé en deux éléments : un élément de mémorisation comprenant la piste 1 munie des bornes A et B et les portions de couches 10, 11 et 12, et un élément de lecture comprenant dans l'exemple donné ci-dessus les couches 13 et 14 et l'électrode C. Avec le même élément de mémorisation, divers modes de lecture pourraient être envisagés, par exemple une lecture optique.

La figure 1C est une vue de dessus simplifiée du plot 3. Seule la piste 1 et le plot 3 sont représentés, ainsi que les bornes A et B connectées à des contacts 15 et 16.

Comme on l'a indiqué précédemment, ce point mémoire est programmable par l'application d'un courant entre les bornes A et B simultanément à l'application d'un champ magnétique ayant une composante non nulle selon la direction du courant. Des exemples de moyens de génération d'un champ magnétique sont donnés dans la demande de brevet susmentionnée. L'application d'un champ externe ou la réalisation de couches magnétiques spécifiques propres à créer le champ H pose des problèmes de réalisation pratique.

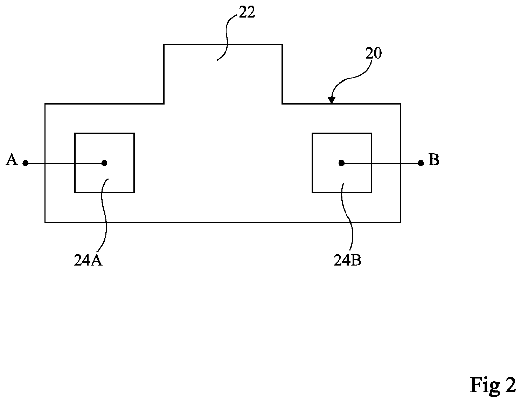

La demande de brevet US 2014/0010004 décrit un point mémoire magnétique qui peut être programmé par l'application d'un courant en l'absence de champ magnétique. La figure 2 est une vue de dessous schématique d'un point mémoire magnétique correspondant aux figures 15C, 16C et 17C de cette demande de brevet. Un plot magnétique 20 comprend un empilement de portions de couches similaires aux couches du plot magnétique 3 décrit en relation avec les figures 1A à 1C. Le plot 20 a une forme de rectangle allongé et comprend, du côté de l'un de ses grands côtés, une portion 22 qui, en vue de dessus, s'étend dans une direction orthogonale au grand côté. Les deux extrémités opposées du rectangle sont reliées à des bornes A et B par des contacts 24A et 24B. La portion 22 confère au plot 20 une asymétrie qui permet de programmer le point mémoire par la seule application d'un courant continu. Le sens de l'écoulement du courant, de la borne A vers la borne B ou de la borne B vers la borne A, définit la valeur programmée.

La programmation de ce point mémoire dépend du sens d'écoulement du courant continu traversant le dispositif. US 2009/0273972 A1, US 2010/0207220 A1 et US 6 707 122 B1 montrent des éléments magnétiques comportant quatre branches de métallisation, le plot ne définissant une direction de circulation préférentielle du courant.

On souhaite disposer d'un point mémoire dont la programmation ne dépende pas du sens d'un courant circulant entre deux bornes de programmation, le courant pouvant avoir une polarité quelconque ou même notamment être alternatif.

### Résumé

Ainsi, un mode de réalisation prévoit un point mémoire magnétique, comprenant : un plot comportant une portion de couche magnétique entre une portion de couche conductrice et une portion de couche différente de la couche conductrice, la couche magnétique ayant une aimantation perpendiculaire au plan des couches ; une portion de métallisation sur laquelle le plot est disposé ; et des première, deuxième, troisième et quatrième branches de métallisation, chaque branche ayant un axe médian, dans lequel, pour chaque branche, un courant circulant vers le plot selon la direction de l'axe médian voit la partie du plot la plus proche de la branche en majorité sur sa gauche pour les première et deuxième branches, et en majorité sur sa droite pour les troisième et quatrième branches.

Selon un mode de réalisation, la couche magnétique a une épaisseur inférieure à 3 nm.

Selon un mode de réalisation, le point mémoire magnétique présente en vue de dessus un centre de symétrie.

Selon un mode de réalisation, le point mémoire magnétique présente un plan de symétrie perpendiculaire au plan des couches, les première et troisième branches étant symétriques l'une de l'autre par rapport au plan de symétrie et les deuxième et quatrième branche étant symétriques l'une de l'autre par rapport au plan de symétrie.

Selon un mode de réalisation, pour chaque branche, la partie du plot la plus proche de la branche comprend une portion allongée dans une direction faisant, en vue de dessus, un angle aigu avec l'axe médian de la branche.

Selon un mode de réalisation, un au moins desdits angles aigus est compris entre 30° et 60°.

Selon un mode de réalisation, une au moins desdites portions allongées forme une pointe.

Selon un mode de réalisation, une au moins desdites portions allongées forme une pointe arrondie.

Selon un mode de réalisation, la portion de métallisation et les première, deuxième, troisième et quatrième branches forment une croix, le plot étant de forme allongée et étant disposé au centre de la croix.

Selon un mode de réalisation, le plot comprend une portion centrale allongée dans une direction faisant un angle compris entre 0° et 30° degrés, de préférence entre 5° et 25°, avec l'axe médian de la troisième branche.

Selon un mode de réalisation, les axes médians des première et deuxième branches sont sensiblement colinéaires et les axes médians des troisième et quatrième branches sont sensiblement colinéaires, le plot étant de forme allongée et centré sur le point de rencontre des axes, et lesdits angles aigus étant compris entre 30° et 45°.

Selon un mode de réalisation, les axes médians des première et troisième branches sont sensiblement colinéaires et les axes médians des deuxième et quatrième branches sont sensiblement colinéaires, les axes médians des première et deuxième branches étant sensiblement parallèles, et les première et deuxième branches s'étendant dans des sens opposés.

Selon un mode de réalisation, les axes médians des deuxième et troisième branches sont sensiblement colinéaires et les axes médians des première et quatrième branches sont sensiblement orthogonaux aux axes médians des première et troisième branches.

Un autre mode de réalisation prévoit un procédé de programmation d'un point mémoire, comprenant une étape consistant à faire passer un premier courant entre la première et la deuxième branche ou un deuxième courant entre la troisième et la quatrième branche.

Selon un mode de réalisation, le premier ou le deuxième courant est un courant alternatif.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B sont respectivement une vue schématique en coupe et une vue schématique en perspective d'un point mémoire magnétique ;
la figure 1C est une vue de dessus simplifiée du point mémoire magnétique illustré en figures 1A et 1B ;
la figure 2 est une vue de dessus schématique d'un point mémoire magnétique ;
les figures 3A et 3B sont respectivement une vue schématique en perspective et une vue schématique de dessus d'un mode de réalisation d'un point mémoire magnétique ;
la figure 4 illustre le fonctionnement du mode de réalisation représenté en figure 3 ; et
les figures 5A à 5E sont des vues de dessus schématiques d'autres modes de réalisation d'un point mémoire magnétique.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés.

Dans la description qui suit, sauf précision contraire, lorsque l'on fait référence à des qualificatifs de position absolue, tels que les termes "haut", "bas", "gauche", "droite", etc., ou relative, tels que les termes "dessus", "dessous", "supérieur", etc., il est fait référence à l'orientation de l'élément concerné dans les figures 1A, 1B, 3A et 4. Sauf précision contraire, les expressions "approxima-tivement", "sensiblement", et "de l'ordre de" signifient à 10 % près, de préférence à 5 % près, ou, s'agissant d'une orientation, à 15 degrés près, de préférence à 10 degrés près.

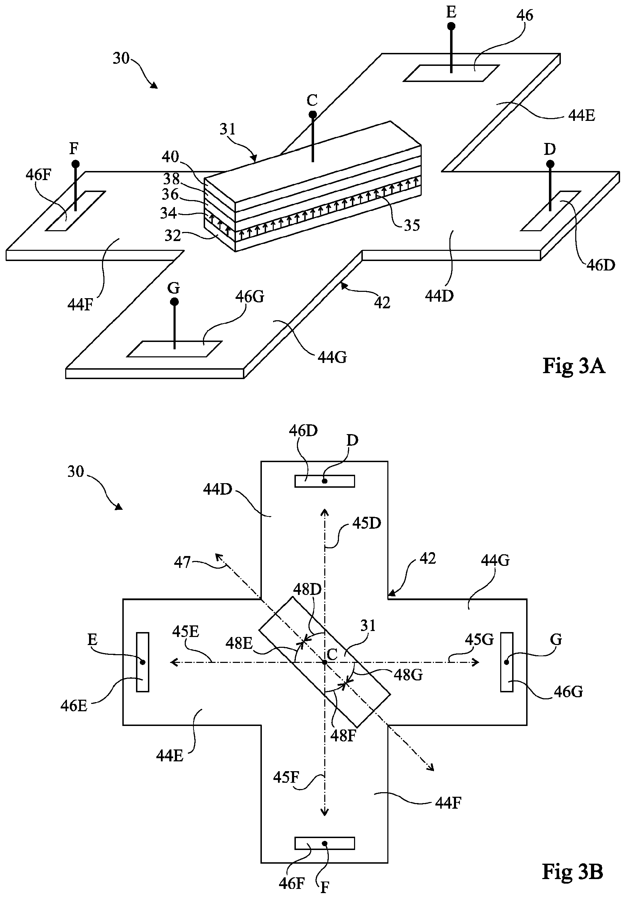

Les figures 3A et 3B sont respectivement une vue schématique en perspective et une vue schématique de dessus d'un mode de réalisation d'un point mémoire magnétique 30.

Le point mémoire magnétique 30 comprend un plot 31 formé d'un empilement de portions de couches. Le plot 31 comprend, de bas en haut, une portion de couche conductrice 32, une portion de couche magnétique programmable 34 ayant une aimantation 35 orthogonale au plan des couches, une portion de couche non magnétique 36 différente de la couche 32, une portion de couche magnétique 38 et une électrode 40. L'électrode 40 est reliée à une borne C. Les couches 32, 34, 36, 38 et 40 sont similaires aux couches minces formant les régions respectives 10, 11, 12, 13 et 14 décrites en relation avec les figures 1A à 1C. En particulier, les variantes décrites en relation avec les figures 1A à 1C sont applicables.

Le plot 31 est disposé sur la portion centrale d'une métallisation 42 ayant, en vue de dessus, la forme d'une croix à quatre branches. Les quatre branches 44D, 44E, 44F et 44G ont des axes médians 45D, 45E, 45F, 45G formant des angles droits. Les branches sont connectées à des bornes respectives D, E, F et G par des contacts respectifs 46D, 46E, 46F et 46G situés aux extrémités des branches. Le plot 31 a en vue de dessus la forme d'un rectangle allongé dans une direction 47 faisant des angles aigus sensiblement égaux à 45 degrés avec les axes 45D, 45E, 45F et 45G.

Les angles aigus 48D et 48F entre les axes 45D et 45F des branches opposées 44D et 44F et la direction 47 sont orientés dans le sens antihoraire. Les angles aigus 48E et 48G entre les axes 45E et 45G des branches opposées 44E et 44G et la direction 47 sont orientés dans le sens horaire. Dans cette configuration, un observateur placé sur l'une ou l'autre des branches opposées 44D et 44F regardant le plot selon les axes 45D et 45F voit sur sa droite la partie du plot la plus proche de lui. Un observateur placé sur l'une ou l'autre des branches opposées 44E et 44G regardant le plot selon les axes 45E et 45G voit sur sa gauche la partie du plot la plus proche de lui.

En fonctionnement, le point mémoire 30 est connecté à un dispositif adapté à faire circuler un courant entre les bornes opposées D et F ou entre les bornes opposées E et G.

Pour programmer le point mémoire 30, les inventeurs ont observé qu'une première orientation est imposée à l'aimantation 35 par la circulation d'un courant entre les bornes opposées D et F, et qu'une orientation inverse est imposée par un courant s'écoulant entre les bornes opposées E et G. Ces orientations sont imposées quel que soit le sens du courant circulant entre les bornes D et F, respectivement E et G.

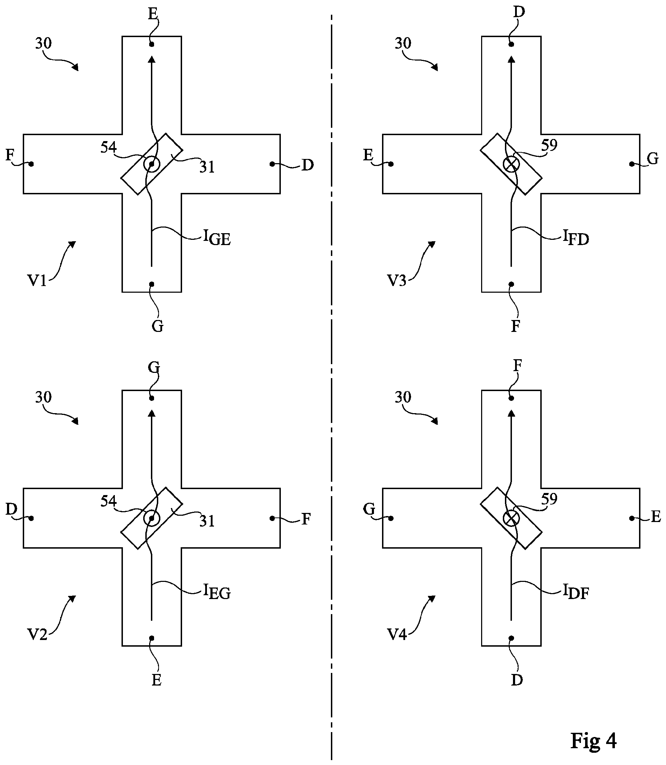

La figure 4 regroupe quatre vues de dessus schématiques V1 à V4 illustrant le fonctionnement du point mémoire 30. La vue V2 correspond à la vue V1 après rotation de 180°, la vue V3 correspond à la vue V1 après rotation de 90° dans le sens antihoraire et la vue V4 correspond à la vue V3 après rotation de 180°. L'orientation de chacune des vues V1 à V4 est telle que les écoulements de courants sont représentés dans des sens identiques, de bas en haut.

Dans la vue V1 en haut à gauche de la figure 4, la borne E est située en haut de la figure. Un courant I_{GE} circule de la borne G vers la borne E. Les inventeurs ont observé que le cheminement du courant I_{GE} dans le plot 31 présente alors la propriété d'imposer une orientation à l'aimantation 35 de la couche magnétique programmable 34. Le cheminement du courant dans le plot et l'action sur les spins des électrons qui en résulte ne sont pas uniformes dans l'ensemble de la couche programmable 34. Il est donc remarquable qu'une orientation imposée s'étende à l'aimantation de l'ensemble de la couche programmable 34. Dans cet exemple, l'orientation 54, dirigée de la couche inférieure 32 vers la couche supérieure 36, est imposée à l'aimantation 35.

Dans la vue V2 en bas à gauche de la figure 4, la borne E est située en bas de la figure. Un courant I_{EG} s'écoule dans le point mémoire 30 de la borne E vers la borne G. En vue de dessus, le point mémoire 30 est symétrique par rapport au centre du plot 31. Le cheminement du courant I_{EG} dans le plot 31 est donc identique au cheminement du courant I_{GE}. Ainsi, l'orientation 54 de l'aimantation 35 est dans le même sens que dans la vue V1. L'orientation imposée à l'aimantation 35 de la couche programmable 34 ne dépend pas du sens d'écoulement du courant circulant entre les bornes E et G.

Dans la vue V3 en haut à droite de la figure 4, la borne D est située en haut de la figure. Un courant I_{FD} s'écoule dans le point mémoire 30 de la borne F vers la borne D. Le cheminement du courant I_{FD} dans le plot 31 est l'image vue dans un miroir du cheminement du courant I_{GE} de la vue V1. Le miroir est perpendiculaire au plan de la figure 4 et parallèle aux branches dans lesquelles le courant s'écoule. L'action sur les spins des électrons localisés responsables de l'aimantation qui résulte du passage du courant I_{FD} est, par rapport au miroir, antisymétrique de l'action qui résulte du passage du courant I_{GE}. Ainsi, une orientation 59, inverse de l'orientation 54 des vues V1 et V2, est imposée à l'aimantation 35 de la couche magnétique programmable 34.

Dans la vue V4 en bas à droite de la figure 4, la borne D est située en bas de la figure. Un courant I_{DF} s'écoule dans le point mémoire 30 de la borne D vers la borne F. Le cheminement du courant I_{DF} dans le plot 31 de la borne D vers la borne F est identique au cheminement du courant I_{FD} de la vue V3. De ce fait, l'orientation de l'aimantation de la couche programmable ne dépend pas du sens du courant circulant entre les bornes D et F.

La lecture du point mémoire 30 s'obtient, d'une manière similaire à la lecture décrite en relation avec les figures 1A et 1B, en mesurant une résistance entre la borne C et l'une quelconque des bornes D, E, F, et G. Les couches supérieures 38 et 40, ainsi que la borne C, constituent un ensemble de lecture. A titre de variante, l'ensemble de lecture peut être omis, et remplacé par exemple par un dispositif de lecture électronique utilisant l'effet hall extraordinaire ou encore un dispositif de lecture optique.

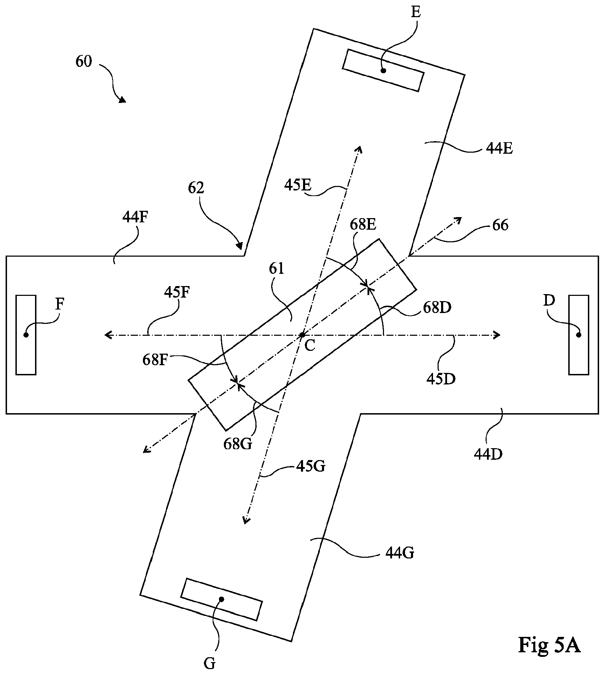

Les figures 5A à 5E sont des vues de dessus schématiques d'autres modes de réalisation d'un point mémoire magnétique. Par souci de clarté, des éléments des points mémoire décrits en relation avec les figures 5A à 5E et des éléments du point mémoire décrit en relation avec les figures 3A et 3B ayant le même rôle sont désignés par de mêmes références.

Chacun des points mémoire magnétiques illustrés en figures 5A à 5E comprend un plot disposé sur une métallisation. Chaque plot comprend une portion d'un empilement de couches semblable à l'empilement de couches du plot 31 décrit en relation avec les figures 3A et 3B. Chaque plot est surmonté d'un contact avec une borne C.

En figure 5A, un point mémoire magnétique 60 comprend un plot 61 disposé sur une métallisation 62 se prolongeant par quatre branches 44D, 44E, 44F et 44G. Les branches 44D et 44F s'étendent dans deux sens opposés selon des axes médians 45D et 45F sensiblement colinéaires. Les branches 44E et 44G s'étendent dans deux sens opposés selon des axes médians 45E et 45G sensiblement colinéaires. Le plot 61 est centré sur un point de rencontre des axes 45D et 45E et a la forme d'un rectangle allongé dans une direction 66 faisant avec les axes médians des angles aigus égaux entre eux, par exemple compris entre 30 et 45°.

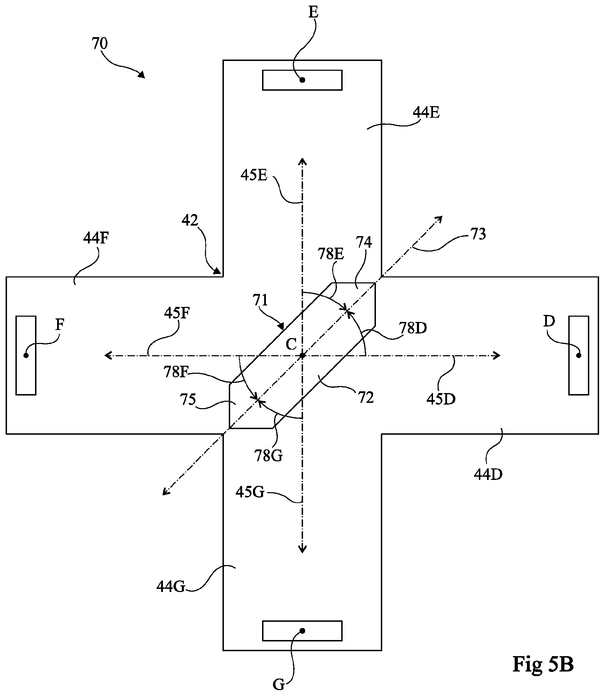

En vue de dessus, les angles aigus 68D et 68F entre les axes 45D et 45F et la direction 66 sont orientés dans le sens antihoraire. Les angles aigus 68E et 68G entre les axes 45E et 45G et la direction 66 sont orientés dans le sens horaire. Le point mémoire 60 est symétrique par rapport au centre du plot 61. De plus, le point mémoire est symétrique par rapport à un miroir perpendiculaire au plan de la figure 5B et contenant l'axe 66. Ainsi, le fonctionnement du point mémoire 60 est similaire au fonctionnement décrit en relation avec les figures 4A à 4D, pour des courants de programmation circulant entre les bornes E et F ou entre les bornes E et G.

En figure 5B, un point mémoire magnétique 70 comprend un plot 71 disposé au centre de la métallisation 42 en forme de croix décrite en relation avec les figures 3A et 3B. Le plot 71 comprend une portion centrale 72 en forme de rectangle allongé selon une direction 73 faisant des angles aigus sensiblement égaux à 45 degrés avec les axes 45D, 45E, 45F et 45G. La portion 72 se prolonge à partir de chacun de ses petits côtés par des portions 74 et 75 en forme de pointe dans la direction 73. Les angles aigus 78D et 78F entre les axes respectifs 45D et 45F des branches opposées 44D et 44F et la direction 73 sont orientés dans le sens antihoraire. Les angles aigus 78E et 78G entre les axes respectifs 45E et 45G des branches opposées 44E et 44G et la direction 73 sont orientés dans le sens horaire.

Le point mémoire 70 présente les mêmes symétries que le point mémoire 30 décrit en relation avec les figures 3A et 3B. Ainsi, le fonctionnement du point mémoire 70 est similaire au fonctionnement du point mémoire 30.

En outre, les inventeurs ont observé que la présence de portions 74, 75 en forme de pointe dans les parties du plot proches des branches présente l'avantage de permettre de programmer le point mémoire avec un courant plus faible.

A titre de variante, la portion centrale 72 peut être omise, Les deux portions 74 et 75 formant alors les pointes d'un losange disposé au centre de la croix et allongé dans la direction 73.

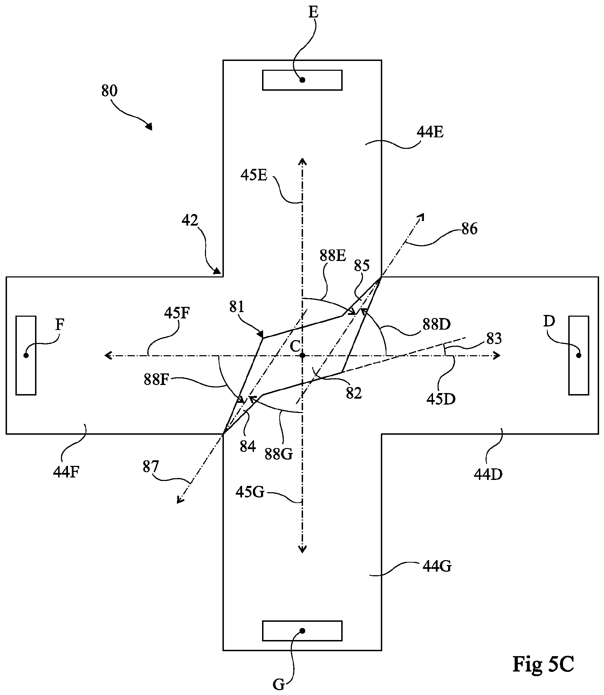

En figure 5C, un point mémoire magnétique 80 comprend un plot 81 disposé au centre de la métallisation 42 décrite en relation avec les figures 3A et 3B. Le plot 81 comprend une portion centrale 82 en forme de parallélogramme dont les grands côtés font un angle aigu 83 inférieur à 45° avec la direction 45D. La portion centrale 82 se prolonge à partir de chacun de ses petits côtés par des portions 84 et 85 en forme de pointe dans des directions respectives 86 et 87 formant des angles aigus avec les axes 45D, 45E, 45F et 45G. La pointe de la portion 85 se situe par exemple sensiblement au point de rencontre entre un bord de la branche 44D et un bord de la branche 44E. La pointe de la portion 85 se situe par exemple sensiblement au point de rencontre entre un bord de la branche 44F et un bord de la branche 44G. Les angles aigus 88D et 88F entre les axes respectifs 45D et 45F et la direction 86 sont orientés dans le sens antihoraire. Les angles aigus 88E et 88G entre les axes respectifs 45E et 45G et la direction 87 sont orientés dans le sens horaire. En vue de dessus, le point mémoire 80 est symétrique par rapport au centre du plot 81. On peut en déduire que la programmation imposée par le passage d'un courant entre des bornes opposées ne dépend pas du sens du courant.

A titre d'exemple, l'angle aigu 83 est de l'ordre de 15°. Les angles aigus 88D et 88F peuvent être de l'ordre de 45°.

Le point mémoire 80 n'est pas symétrique par rapport à un miroir. Cependant, tout comme dans le point magnétique 30 décrit en relation avec les figures 3A et 3B, un courant circulant de l'une des branches 44D ou 44F vers le plot voit sur sa droite la partie du plot la plus proche de lui. Un courant circulant de l'une des branches 44E ou 44G vers le plot voit sur sa gauche la partie du plot la plus proche de lui. Cette conformation du plot par rapport aux branches assure au point mémoire 80 un fonctionnement identique au fonctionnement du point mémoire 30 des figures 3A, 3B et 4.

En effet, lorsqu'un courant s'écoule entre les bornes D et F du point mémoire 30 et lorsqu'un courant s'écoule entre les bornes D et F du point mémoire 80, ces courants ont des cheminements similaires dans les parties des plots les plus proches des branches 44D. De même, ces deux courants ont des cheminements similaires dans les parties des plots les plus proches des branches 44F. Or, ces parties des plots les plus proches des branches déterminent l'orientation imposée à l'aimantation de la couche programmable 34. C'est pourquoi lorsqu'un courant s'écoule de la borne D vers la borne F l'orientation imposée à l'aimantation des couches programmables est identique dans le point mémoire 80 et dans le point mémoire 30. Il en est de même pour des courants circulant de la borne F vers la borne D, de la borne E vers la borne G, et de la borne G vers la borne E.

Le point mémoire 80 peut avoir des portions 84 et 85 en forme de pointes plus aiguës que les portions 74 et 75 du point mémoire 70, ce qui présente l'avantage de permettre l'utilisation de courants d'écriture réduits pour programmer le point mémoire.

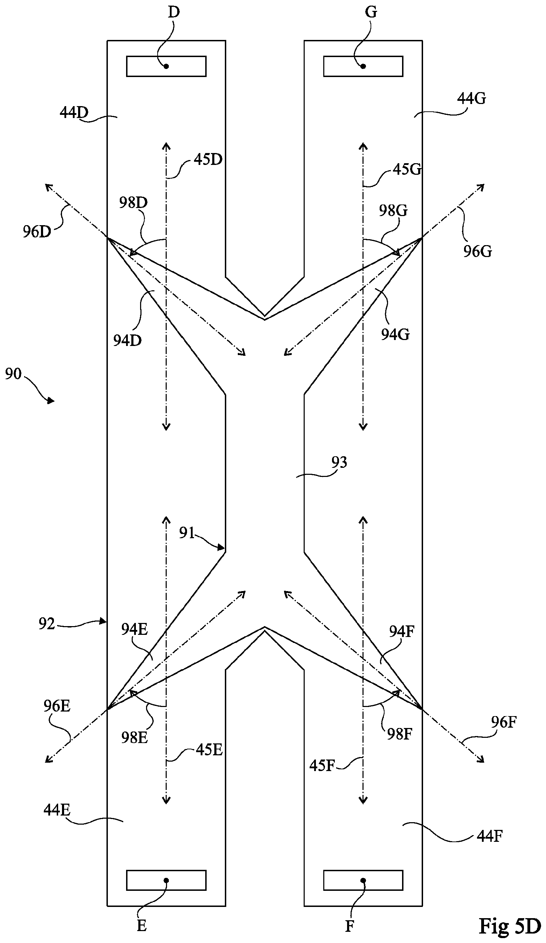

En figure 5D, un point mémoire magnétique 90 comprend un plot 91 disposé sur une métallisation 92 se prolongeant par quatre branches 44D, 44E, 44F et 44G. Les branches 44D et 44E s'étendent dans deux sens opposés selon des axes médians respectifs 45D et 45E sensiblement colinéaires. Les branches 44F et 44G s'étendent de manière sensiblement parallèle aux branches 44D et 44E dans deux sens opposés selon des axes médians respectifs 45F et 45G sensiblement colinéaires. Les branches 44D et 44E sont d'un même côté de la métallisation 92. Le plot 91 comprend une portion centrale 93 en forme de rectangle allongé et centré entre les branches. Pour chaque branche respective 44D, 44E, 44F, 44G, la portion centrale 93 se prolonge, à partir de son petit côté le plus proche de la branche, par une portion allongée 94D, 94E, 94F, 94G dans une direction 96D, 96E, 96F, 96G faisant un angle aigu avec la branche. Chaque portion allongée 94D, 94E, 94F, 94G a la forme d'une pointe qui se rapproche du bord de la branche respective 44D, 44E, 44F, 44G le plus éloigné de la portion centrale 93. L'angle aigu 98D entre l'axe 45D et la direction 96D est orienté dans le sens antihoraire. L'angle aigu 98E entre l'axe 45E et la direction 96E est orienté dans le sens horaire.

L'angle aigu 98F entre l'axe 45F et la direction 96F est orienté dans le sens antihoraire. L'angle aigu 98G entre l'axe 45G et la direction 96G est orienté dans le sens horaire. De plus, le point mémoire 90 présente les mêmes symétries que le point mémoire 30 décrit en relation avec les figures 3A et 3B. Ainsi, le fonctionnement du point mémoire 90 est similaire au fonctionnement du point mémoire 30 pour des courants de programmation circulant entre les bornes D et F ou entre les bornes E et G.

A titre d'exemple, les angles aigus 98D, 98E, 98F, 98G sont approximativement égaux et de l'ordre de 45°.

Le point mémoire 90 présente l'avantage de comporter des portions 94D, 94E, 94F, 94G en forme de pointe permettant de programmer le point mémoire avec un courant réduit. Le point mémoire 90 présente en outre l'avantage d'être alimenté par des branches parallèles dont la disposition facilite l'intégration du point mémoire dans un composant électronique, par exemple dans une mémoire comportant de nombreux points mémoire.

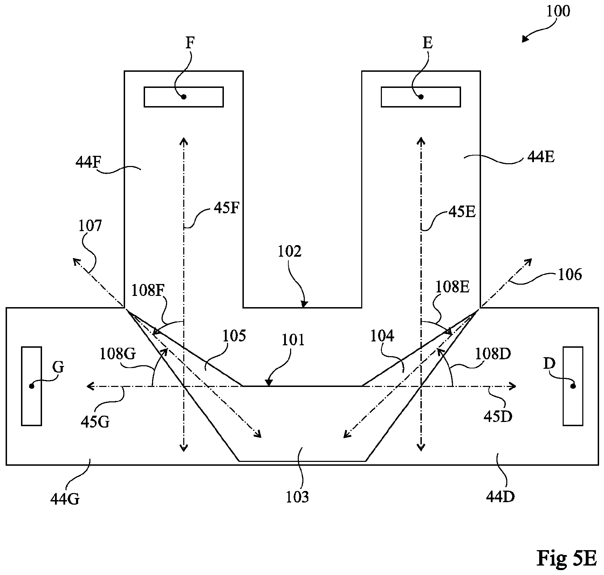

En figure 5E, un point mémoire magnétique 100 comprend un plot 101 disposé sur une métallisation 102 se prolongeant par quatre branches 44D, 44E, 44F et 44G. Les branches 44D et 44G s'étendent dans deux sens opposés selon des axes médians respectifs 45D et 45G sensiblement colinéaires. Les branches 44E et 44F s'étendent d'un même côté des branches 44D et 44G dans une direction sensiblement perpendiculaire aux axes 45D et 45G, selon des axes médians 45E et 45F. Le plot 101 comprend une portion centrale 103 en forme de rectangle allongé selon l'axe 45D. La portion centrale 103 se situe entre les branches 44E et 44F et se trouve en majorité du côté des axes 45D et 45G opposé aux branches 44E et 44F. La portion centrale 103 se prolonge par chacun de ses petits côtés par des portions allongées 104 et 105 en formes de pointes. La portion 104 est située en regard des branches 44D et 44E et s'étend dans une direction 106 en se rapprochant du point de rencontre entre un côté de la branche 44D et un côté de la branche 44E. La portion 105 est située en regard des branches 44F et 44G et s'étend dans une direction 107 en se rapprochant du point de rencontre entre un côté de la branche 44F et un côté de la branche 44G. L'angle aigu 108D entre l'axe 45D et la direction 106 est orienté dans le sens antihoraire. L'angle aigu 108F entre l'axe 45F et la direction 107 est orienté dans le sens antihoraire. L'angle aigu 108E entre l'axe 45E et la direction 106 est orienté dans le sens horaire. L'angle aigu 108G entre l'axe 45G et la direction 107 est orienté dans le sens horaire. A titre d'exemple, l'angle aigu 108D est de l'ordre de 45°. L'angle aigu 108E peut être de l'ordre de 45°.

Dans la configuration du point mémoire 100, un courant circulant de l'une ou l'autre des branches 44D et 44F vers le plot selon les axes 45D et 45F voit sur sa droite la partie du plot la plus proche de lui. Un courant circulant de l'une ou l'autre des branches 44E et 44G vers le plot selon les axes 45E et 45G voit sur sa gauche la partie du plot la plus proche de lui. Ainsi, le fonctionnement du point mémoire 100 est similaire au fonctionnement du point mémoire 80 décrit en relation avec la figure 5D.

La disposition des branches peut faciliter la mise en oeuvre du point mémoire 100, par exemple dans un dispositif électronique tel qu'une mémoire comportant de nombreux points mémoire.

A titre de variante, la branche 44E du point mémoire 100 peut être remplacée par une branche 44E symétrique de la branche 44E représentée en figure 5E par rapport à l'axe 45D. On notera que dans cette variante, l'angle aigu 108E et son orientation ne sont pas modifiés.

A titre d'exemple, les dimensions des branches 44D à 44F des figures 3A, 3B et 5A à 5E mesurées dans un sens orthogonal aux axes médians 45D à 45F, sont comprises entre 10 nm et 200 nm.

Le courant utilisé pour programmer le point magnétique est par exemple compris entre 10⁵ A/cm2 et 10⁸ A/cm2.

La couche magnétique programmable peut comporter un alliage présentant une anisotropie magnétique perpendiculaire propre, notamment FePt, FePd, CoPt, ou un alliage de terre rare / métal de transition, notamment GdCo, TdFeCo. La couche magnétique programmable peut comporter un métal ou un alliage présentant dans l'empilement une anisotropie magnétique perpendiculaire induite par les interfaces, notamment Co, Fe, CoFe, Ni, CoNi.

L'une des couches 32, 36 prenant en sandwich la couche magnétique programmable 34 peut être en un métal non magnétique, tel que Pt, W, Ir, Ru, Pd, Cu, Au, Bi, Hf ou en alliage de ces métaux ou sous la forme d'un empilement de plusieurs couches de chacun de ces métaux.

La couche conductrice 32 peut être en un matériau non magnétique ou antiferromagnétique. A titre d'exemple de matériaux antiferromagnétiques, on peut citer des alliages à base de Mn tels que IrMn, FeMn, PtMn, ou des alliages de ces composés comme PtFeMn ou des oxydes tels ou CoOx ou NiOx. La conductivité de la couche inférieure 32 doit être suffisante pour permettre le passage d'un courant dans la phase d'écriture.

La couche non magnétique 36 surmontant la couche magnétique programmable peut être en un oxyde diélectrique tel que SiOx, AlOx, MgOx, TaOx, HfOx, ou en un nitrure diélectrique tel que SiN, BNx, d'une épaisseur propre à autoriser un effet tunnel.

L'épaisseur d'une des couches 32, 36 prenant en sandwich la couche magnétique programmable peut être comprise entre 0,5 nm et 200 nm, plus particulièrement entre 0,5 nm et 100 nm, et préférentiellement inférieure à 3 nm.

L'épaisseur de la couche magnétique programmable peut être inférieure à 3 nm.

La couche magnétique 38 de l'ensemble de lecture peut être en un matériau magnétique, ou en un composé de matériaux magnétiques, ou comprendre plusieurs couches de matériaux magnétiques et non magnétiques.

Un avantage des points mémoire magnétiques décrits ci-dessus est que le courant de programmation peut-être alternatif, et que s'il est continu on n'a pas à se soucier de son sens.

Des modes de réalisation particuliers ont été décrits. Diverses variantes et modifications apparaîtront à l'homme de l'art. En particulier, bien que des configurations particulières de plots disposés sur une métallisation aient été décrites, d'autres configurations sont possibles dans la condition que, pour chaque branche, un observateur extérieur placé sur la branche regardant le plot selon la direction de l'axe médian de la branche voie la partie du plot la plus proche de la branche en majorité sur sa gauche pour deux des branches, et en majorité sur sa droite pour les deux autres branches.

De plus, bien que les plots des points mémoire magnétiques décrits ci-dessus aient tous des formes présentant des angles vifs, les formes réelles peuvent être arrondies. En particulier les pointes peuvent être arrondies, le rayon de courbure étant de préférence compris entre 1 et 10 nm.

En outre, le terme "métallisation" doit être interprété comme désignant un matériau conducteur métallique ou non métallique, par exemple un semiconducteur dopé.

De plus, bien que dans les points mémoire décrits, la couche de programmation soit recouverte d'une couche non magnétique, cette couche non magnétique peut être remplacée par une couche magnétique ou comprendre plusieurs couches de matériaux magnétiques et non magnétiques, l'important étant que les couches prenant en sandwich la couche de programmation soient différentes.

En outre, bien que, dans les points mémoire décrits, les métallisations se prolongent par des branches rectilignes, ces métallisations peuvent aussi se prolonger par des branches incurvées ayant dans leurs parties les plus proches du plot la même direction que les branches rectilignes, et ayant des axes médians définis par les axes médians des branches rectilignes.

## Revendications

1. Point mémoire magnétique (30 ; 60 ; 70 ; 80 ; 90 ; 100), comprenant :
un plot (31 ; 61 ; 71 ; 81 ; 91 ; 101) comportant une portion de couche magnétique (34) entre une portion de couche conductrice (32) et une portion de couche (36) différente de la couche conductrice, la couche magnétique ayant une aimantation (35) perpendiculaire au plan des couches ;
une portion de métallisation (42 ; 62 ; 72 ; 82 ; 92 ; 102) sur laquelle le plot est disposé ; et
des première, deuxième, troisième et quatrième branches (44D à 44G) de métallisation, chaque branche ayant un axe médian (45D à 45G),
dans lequel, pour chaque branche, un courant circulant vers le plot selon la direction de l'axe médian voit la partie du plot la plus proche de la branche en majorité sur sa gauche pour les première et deuxième branches (44E, 44G), et en majorité sur sa droite pour les troisième et quatrième branches (44D, 44F).

2. Point mémoire magnétique (30 ; 60 ; 70 ; 80 ; 90 ; 100) selon la revendication 1, dans lequel la couche magnétique a une épaisseur inférieure à 3 nm.

3. Point mémoire magnétique (30 ; 60 ; 70 ; 80 ; 90) selon la revendication 1 ou 2, présentant en vue de dessus un centre de symétrie.

4. Point mémoire magnétique (30 ; 60 ; 70 ; 90) selon l'une quelconque des revendications 1 à 3, présentant un plan de symétrie perpendiculaire au plan des couches, les première et troisième branches (44E, 44D) étant symétriques l'une de l'autre par rapport au plan de symétrie et les deuxième et quatrième branches (44G, 44F) étant symétriques l'une de l'autre par rapport au plan de symétrie.

5. Point mémoire magnétique (30 ; 60 ; 70 ; 80 ; 90 ; 100) selon l'une quelconque des revendications 1 à 4, dans lequel, pour chaque branche (44D à 44G), la partie du plot la plus proche de la branche comprend une portion allongée (31 ; 61 ; 74, 75 ; 84, 85 ; 94D à 94G ; 104, 105) dans une direction faisant, en vue de dessus, un angle aigu avec l'axe médian (45D à 45G) de la branche.

6. Point mémoire magnétique (30 ; 60 ; 70 ; 80 ; 90 ; 100) selon la revendication 5, dans lequel un au moins desdits angles aigus est compris entre 30° et 60°.

7. Point mémoire magnétique (70 ; 80 ; 90 ; 100) selon la revendication 5 ou 6, dans lequel une au moins desdites portions allongées (74, 75 ; 84, 85 ; 94D à 94G ; 104, 105) forme une pointe.

8. Point mémoire magnétique (70 ; 80 ; 90 ; 100) selon la revendication 5 ou 6, dans lequel une au moins desdites portions allongées (74, 75 ; 84, 85 ; 94D à 94G ; 104, 105) forme une pointe arrondie.

9. Point mémoire magnétique (30 ; 70 ; 80) selon l'une quelconque des revendications 5 à 8, dans lequel la portion de métallisation (42) et les première, deuxième, troisième et quatrième branches (44D à 44G) forment une croix, le plot (31 ; 71 ; 81) étant de forme allongée et étant disposé au centre de la croix.

10. Point mémoire magnétique (80) selon la revendication 9, dans lequel le plot (81) comprend une portion centrale (82) allongée dans une direction faisant un angle (83) compris entre 0° et 30° degrés, de préférence entre 5° et 25°, avec l'axe médian (45D) de la troisième branche (44D).

11. Point mémoire magnétique (60) selon l'une quelconque des revendications 5 à 8, dans lequel les axes médians (45E, 45G) des première et deuxième branches (44E, 44G) sont sensiblement colinéaires et les axes médians (45D, 45F) des troisième et quatrième branches (44D, 44F) sont sensiblement colinéaires, le plot (61) étant de forme allongée et centré sur le point de rencontre des axes, et lesdits angles aigus (68D à 68G) étant compris entre 30° et 45°.

12. Point mémoire magnétique (90) selon l'une quelconque des revendications 5 à 8, dans lequel les axes médians (45E, 45D) des première et troisième branches (44E, 44D) sont sensiblement colinéaires et les axes médians (45G, 45F) des deuxième et quatrième branches (44G, 44F) sont sensiblement colinéaires, les axes médians (45E, 45G) des première et deuxième branches (44E, 44G) étant sensiblement parallèles, et les première et deuxième branches s'étendant dans des sens opposés.

13. Point mémoire magnétique (100) selon l'une quelconque des revendications 5 à 8, dans lequel les axes médians (45G, 45D) des deuxième et troisième branches (44G, 44D) sont sensiblement colinéaires et les axes médians (45E, 45F) des première et quatrième branches (44E, 44F) sont sensiblement orthogonaux aux axes médians des première et troisième branches.

14. Procédé de programmation d'un point mémoire (30 ; 60 ; 70 ; 80 ; 90 ; 100) selon l'une quelconque des revendications 1 à 13, comprenant une étape consistant à faire passer un premier courant (I_{GE}, I_{EG}) entre la première et la deuxième branche (44E, 44G) ou un deuxième courant (I_{DF}, I_{FD}) entre la troisième et la quatrième branche (44D, 44F).

15. Procédé selon la revendication 14, dans lequel le premier ou le deuxième courant (I_{GE}, I_{EG}) est un courant alternatif.

## Patentansprüche

1. Magnetische Speicherstelle (30; 60; 70; 80; 90; 100), welche aufweist:
einen Block (31; 61; 71; 81; 91; 101), welcher einen Abschnitt einer magnetischen Schicht (34) zwischen einem Abschnitt einer leitenden Schicht (32) und einem Abschnitt einer Schicht (36), die verschieden von der leitenden Schicht ist, aufweist, wobei die magnetische Schicht eine Magnetisierung (35) hat, die senkrecht zur Ebene der Schichten ist,
einen Metallisierungsabschnitt (42; 62; 72; 82; 92; 102), an welchem der Block angeordnet ist, und
einen ersten, einen zweiten, einen dritten und einen vierten Zweig (44D bis 44G) der Metallisierung, wobei jeder Zweig eine Mittellachse (45D bis 45G) hat,
wobei für jeden Zweig ein Strom, der in Richtung des Blocks entlang der Richtung der Mittellachse fließt, den Teil des Blocks, der am nächsten zu dem Zweig ist, hauptsächlich auf seiner Linken für den ersten und den zweiten Zweig (44E, 44G) und hauptsächlich auf seiner Rechten für den dritten und den vierten Zweig (44D, 44F) sieht.

2. Magnetische Speicherstelle (30; 60; 70; 80; 90; 100) gemäß Anspruch 1, wobei die magnetische Schicht eine Dicke hat, die geringer als 3 nm ist.

3. Magnetische Speicherstelle (30; 60; 70; 80; 90) gemäß Anspruch 1 oder 2, die in Sicht von oben ein Symmetriezentrum aufweist.

4. Magnetische Speicherstelle (30; 60; 70; 90) gemäß irgendeinem der Ansprüche 1 bis 3, welche eine Symmetrieebene aufweist, die senkrecht zur Ebene der Schichten ist, wobei der erste und der dritte Zweig (44E, 44D) zueinander symmetrisch bezüglich der Symmetrieebene sind und der zweite und der vierte Zweig (44G, 44F) zueinander symmetrisch bezüglich der Symmetrieebene sind.

5. Magnetische Speicherstelle (30; 60; 70; 80; 90; 100) gemäß irgendeinem der Ansprüche 1 bis 4, wobei für jeden Zweig (44D bis 44G) der Teil des Blocks, der am nächsten zu dem Zweig ist, einen langgestreckten Abschnitt (31; 61; 74, 75; 84, 85; 94D bis 94G; 104, 105) in einer Richtung aufweist, die in Sicht von oben einen spitzen Winkel mit der Mittelachse (45D bis 45G) des Zweigs bildet.

6. Magnetische Speicherstelle (30; 60; 70; 80; 90; 100) gemäß Anspruch 5, wobei mindestens einer der besagten spitzen Winkel zwischen 30° und 60° enthalten ist.

7. Magnetische Speicherstelle (70; 80; 90; 100) gemäß Anspruch 5 oder 6, wobei mindestens einer der besagten langgestreckten Abschnitte (74, 75; 84, 85; 94D bis 94G; 104, 105) eine Spitze bildet.

8. Magnetische Speicherstelle (70; 80; 90; 100) gemäß Anspruch 5 oder 6, wobei mindestens einer der besagten langgestreckten Abschnitte (74, 75; 84, 85; 94D bis 94G; 104, 105) eine abgerundete Spitze bildet.

9. Magnetische Speicherstelle (30; 70; 80) gemäß irgendeinem der Ansprüche 5 bis 8, wobei der Metallisierungsabschnitt (42) und der erste, der zweite, der dritte und der vierte Zweig (44D bis 44G) ein Kreuz bilden, wobei der Block (31; 71; 81) von langgestreckter Form und im Zentrum des Kreuzes angeordnet ist.

10. Magnetische Speicherstelle (80) gemäß Anspruch 9, wobei der Block (81) einen zentralen Abschnitt (82) aufweist, der in einer Richtung langgestreckt ist, die einen Winkel (83), der zwischen 0° und 30° Grad, vorzugsweise zwischen 5° und 25°, enthalten ist, mit der Mittelachse (45D) des dritten Zweiges (44D) bildet.

11. Magnetische Speicherstelle (60) gemäß irgendeinem der Ansprüche 5 bis 8, wobei die Mittelachsen (45E, 45G) des ersten und des zweiten Zweiges (44E, 44G) im Wesentlichen kollinear sind und die Mittelachsen (45D, 45F) des dritten und des vierten Zweiges (44D, 44F) im Wesentlichen kollinear sind, wobei der Block (61) von langgestreckter Form ist und an dem Zusammentreffpunkt der Achsen zentriert ist, und wobei die besagten spitzen Winkel (68D bis 68G) zwischen 30° und 45° enthalten sind.

12. Magnetische Speicherstelle (90) gemäß irgendeinem der Ansprüche 5 bis 8, wobei die Mittelachsen (45E, 45D) des ersten und des dritten Zweiges (44E, 44D) im Wesentlichen kollinear sind und die Mittelachsen (45G, 45F) des zweiten und des vierten Zweiges (44G, 44F) im Wesentlichen kollinear sind, wobei die Mittelachsen (45E, 45G) des ersten und des zweiten Zweiges (44E, 44G) im Wesentlichen parallel sind und sich der erste und der zweite Zweig in entgegengesetzten Richtungen erstrecken.

13. Magnetische Speicherstelle (100) gemäß irgendeinem der Ansprüche 5 bis 8, wobei die Mittelachsen (45G, 45D) des zweiten und des dritten Zweiges (44G, 44D) im Wesentlichen kollinear sind und die Mittelachsen (45E, 45F) des ersten und des vierten Zweiges (44E, 44F) im Wesentlichen senkrecht zu den Mittelachsen des ersten und des dritten Zweiges sind.

14. Verfahren zum Programmieren einer Speicherstelle (30; 60; 70; 80; 90; 100) gemäß irgendeinem der Ansprüche 1 bis 13, aufweisend einen Schritt, bestehend aus dem Durchleiten eines ersten Stroms (I_{GE}, I_{EG}) zwischen dem ersten und dem zweiten Zweig (44E, 44G) oder eines zweiten Stroms (I_{DF}, I_{FD}) zwischen dem dritten und dem vierten Zweig (44D, 44F).

15. Verfahren gemäß Anspruch 14, wobei der erste oder der zweite Strom (I_{GE}, I_{EG}) ein Wechselstrom ist.

## Claims

1. A magnetic memory cell (30; 60; 70; 80; 90; 100), comprising:
a stack (31; 61; 71; 81; 91; 101) including a magnetic layer section (34) between a conductive layer section (32) and a section of the layer (36) that is different from the conductive layer, the magnetic layer having a magnetization (35) perpendicular to the plane of the layers;
a metallization section (42; 62; 72; 82; 92; 102) on which the stack is placed; and
first, second, third and fourth metallization arms (44D to 44G), each arm having a median axis (45D to 45G),
wherein, for each arm, a current flowing towards the stack in the direction of the median axis sees that section of the stack which is closest to the arm mostly on its left for the first and second arms (44E, 44G), and mostly on its right for the third and fourth arms (44D, 44F).

2. The magnetic memory cell (30; 60; 70; 80; 90; 100) according to claim 1, wherein the magnetic layer has a thickness smaller than 3 nm.

3. The magnetic memory cell (30; 60; 70; 80; 90) according to claim 1 or 2, having a center of symmetry in top view.

4. The magnetic memory cell (30; 60; 70; 90) according to any one of claims 1 to 3, having a plane of symmetry perpendicular to the plane of the layers, the first and third arms (44E, 44D) being symmetrical to one another relative to the plane of symmetry and at the second and fourth arms (44G, 44F) being symmetrical to one another relative to the plane of symmetry.

5. The magnetic memory cell (30; 60; 70; 80; 90; 100) according to any one of claims 1 to 4, wherein, for each arm (44D to 44G), the part of the stack closest to the arm comprises a portion (31; 61; 74, 75; 84, 85; 94D to 94G; 104, 105) elongated in a direction forming, in top view, an acute angle with the median axis (45D to 45G) of the arm.

6. The magnetic memory cell (30; 60; 70; 80; 90; 100) according to claim 5, wherein at least one of said acute angles is comprised between 30° and 60°.

7. The magnetic memory cell (70; 80; 90; 100) according to claim 5 or 6, wherein at least one of said elongated portions (74, 75; 84, 85; 94D to 94G; 104, 105) forms a tip.

8. The magnetic memory cell (70; 80; 90; 100) according to claim 5 or 6, wherein at least one of said elongated portions (74, 75; 84, 85; 94D to 94G; 104, 105) forms a rounded tip.

9. The magnetic memory cell (30; 70; 80) according to any one of claims 5 to 8, wherein the metallization portion (42) and the first, second, third and fourth arms (44D to 44G) form a cross, the stack (31; 71; 81) being elongated and being positioned at the center of the cross.

10. The magnetic memory cell (80) according to claim 9, wherein the stack (81) comprises a central portion (82) elongated in a direction forming an angle (83) comprised between 0° and 30°, preferably between 5° and 25°, with the median axis (45D) of the third arm (44D).

11. The magnetic memory cell (60) according to any one of claims 5 to 8, wherein the median axes (45E, 45G) of the first and second arms (44E, 44G) are substantially collinear and the median axes (45D, 45F) of the third and fourth arms (44D, 44F) are substantially collinear, the stack (61) having an elongated shape centered on the meeting point of the axes, and said acute angles (68D to 68G) being comprised between 30° and 45°.

12. The magnetic memory cell (90) according to any one of claims 5 to 8, wherein the median axes (45E, 45D) of the first and third arms (44E, 44D) are substantially collinear and the median axes (45G, 45F) of the second and fourth arms (44G, 44F) are substantially collinear, the median axes (45E, 45G) of the first and second arms (44E, 44G) being substantially parallel, and the first and second arms extending in opposite directions.

13. The magnetic memory cell (100) according to any one of claims 5 to 8, wherein the median axes (45G, 45D) of the second and third arms (44G, 44D) are substantially collinear and the median axes (45E, 45F) of the first and fourth arms (44E, 44F) are substantially orthogonal to the median axes of the first and third arms.

14. A method for programming a memory cell (30; 60; 70; 80; 90; 100) according to any one of claims 1 to 13, comprising a step consisting of passing a first current (I_{GE}, I_{EG}) between the first and second arms (44E, 44G) or a second current (I_{DF}, I_{FD}) between the third and fourth arms (44D, 44F).

15. The method according to claim 14, wherein the first or second current (I_{GE}, I_{EG}) is an alternating current.
